(19) **Europäisches Patentamt**

**European Patent Office**

**Office européen des brevets**

(11) **EP 0 598 582 B1**

(12) **EUROPEAN PATENT SPECIFICATION**

(45) Date of publication and mention
of the grant of the patent:
**30.01.2002 Bulletin 2002/05**

(51) Int Cl.7: **G01N 21/88**, G03F 7/20

(21) Application number: **93309113.4**

(22) Date of filing: **15.11.1993**

(54) **INSPECTION METHOD AND APPARATUS**

INSPEKTIONSVERFAHREN UND -VORRICHTUNG

PROCEDE ET APPAREIL DE CONTROLE

(84) Designated Contracting States:
**AT BE CH DE DK ES FR GB GR IE IT LI LU NL PT SE**

(30) Priority: **16.11.1992 JP 30542292**
**10.02.1993 JP 2267593**
**26.04.1993 JP 9954193**

(43) Date of publication of application:
**25.05.1994 Bulletin 1994/21**

(73) Proprietor: **CANON KABUSHIKI KAISHA**
**Tokyo (JP)**

(72) Inventors:
• **Yoshii, Minoru, c/o Canon Kabushiki Kaisha**
**Tokyo (JP)**
• **Nose, Noriyuki, c/o Canon Kabushiki Kaisha**
**Tokyo (JP)**
• **Mori, Tetsuzo, c/o Canon Kabushiki Kaisha**
**Tokyo (JP)**
• **Miyazaki, Kyoichi, c/o Canon Kabushiki Kaisha**
**Tokyo (JP)**
• **Tsuji, Toshihiko, c/o Canon Kabushiki Kaisha**
**Tokyo (JP)**
• **Takeuchi, Seiji, c/o Canon Kabushiki Kaisha**
**Tokyo (JP)**

(74) Representative:
**Beresford, Keith Denis Lewis et al**
**BERESFORD & Co. 2-5 Warwick Court, High Holborn**
**London WC1R 5DH (GB)**

(56) References cited:
EP-A- 0 567 701          DE-A- 3 714 305
US-A- 4 710 026          US-A- 4 898 471

• PATENT ABSTRACTS OF JAPAN vol. 015, no. 091 (P-1175) 5 March 1991 & JP-A-02 307 046 (HITACHI ELECTRON ENG CO LTD) 20 December 1990
• PATENT ABSTRACTS OF JAPAN vol. 011, no. 112 (P-565) 9 April 1987 & JP-A-61 260 211 (HITACHI LTD) 18 November 1986
• PATENT ABSTRACTS OF JAPAN vol. 016, no. 046 (P-1307) 5 February 1992 & JP-A-03 249 550 (MITSUBISHI ELECTRIC CORP) 7 November 1991 & US-A-5 170 063 (KOSAKA N ET AL)
• HITACHI REVIEW, DEC. 1991, JAPAN, VOL. 40, NR. 6, PAGE(S) 395 - 400, ISSN 0018-277X Nishino T et al 'Reticle particle detection system'

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

FIELD OF THE INVENTION AND RELATED ART

This invention relates to a method and an apparatus usable, as an example, in the manufacture of microdevices such as semiconductor devices, for inspecting the surface of an article. More particularly, the invention is concerned with a method and an apparatus for optically inspecting the presence/absence of minute particles or defects of the surface of an article. In another aspect, the invention is concerned with a method and an apparatus for manufacturing microdevices such as semiconductor devices by using such an inspection method.

For manufacture of semiconductor devices such as ICs or liquid crystal displays, for example, a circuit pattern formed on an original (called "reticle" or "photomask") is transferred to the surface of a workpiece or wafer having a resist coating by using a semiconductor printing apparatus (called "exposure apparatus"). If in this transfer process there are minute particles (foreign particles) on the surface of the original, also such particles are transferred (printed) on the wafer. This causes decreased yield of IC manufacture. Particularly, in a case where the same circuit pattern is printed on different zones of a wafer sequentially in accordance with the step-and-repeat method, only one particle on the original is printed on every zone of the wafer. This results in a possibility that all the chips produced from this wafer are defective, leading to a substantial decrease in the yield of IC manufacture.

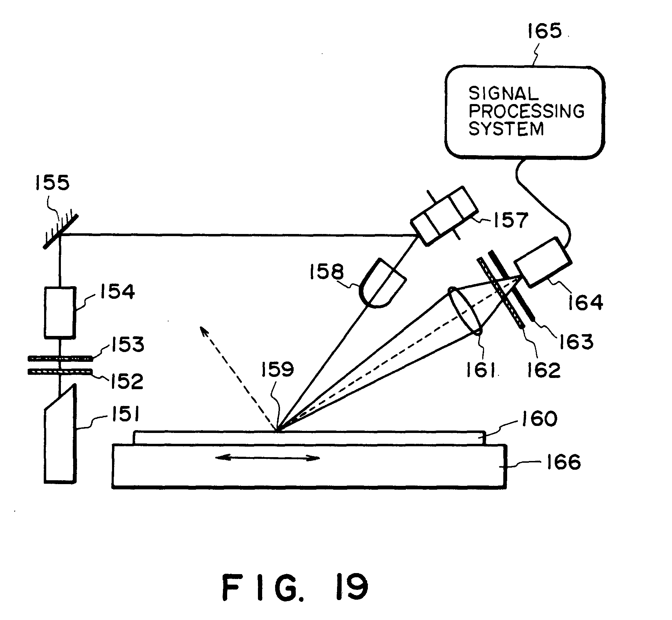

In the IC manufacturing process, it is therefore desired to inspect the presence/absence of minute particles on an original, and many proposals have been made in this respect. Figure 19 shows an example of inspection apparatus. In this example, the presence/absence of any foreign particle is examined by detecting scattered light from the particle.

For example, in Figure 19, a laser beam from a laser light source 151 is transformed into a laser beam best suited to inspection, by means of a polarizer 152, a filter 153, a collimating system 154 and so on. Mirror 155 directs the laser beam to a scanning optical system comprising a scanning mirror 157 and an f-9 lens 158. The scanning laser beam from the f-θ lens 158 is converged on the surface 160, to be inspected, of a reticle or the like having a circuit pattern formed thereon, and thus a scanning light spot 159 is formed thereon. Scanning stage system 166 serves to relatively move the scanning spot 159 and the surface 160 in a direction perpendicular to the direction of scan by the scanning spot 159, whereby two-dimensional scan of the whole of the surface 160 is assured.

A detection system comprising a lens system 161, a polarizer 162, an aperture 163 and a photoelectric detector 164 is disposed to receive backward or sideward scattered light. As regards the disposition of this detection system, since there is scattered light from the circuit pattern or the like on the surface 160 which light has a particular direction of diffraction, the detection system has to be disposed off such direction so as not to receive the unwanted diffraction light.

If in this structure there is no particle within the range of the scanning spot 159, no scattered light is detected by the photoelectric detector 164. If there is any particle, it produces scattered light isotropically and, therefore, the photoelectric detector 164 detects any scattered light. Thus, by processing an output signal of the detector in a signal processing system 165, the presence/absence of any foreign particle on the surface can be inspected.

However, this type of inspection apparatus involves such inconveniences as follows:

(1) Where a very small particle of a size of about 0.3 micron or less is to be detected, the produced scattered light has a very low intensity. It is therefore not easy to detect the particle-scattered light with good sensitivity.

(2) There is a case wherein, depending on the circuit pattern used, scattered light goes from the pattern toward the detector. In the detection system like this example which is based only on the intensity information of the scattered light, it is not easy to discriminate the particle-scattered light from the pattern-scattered light. This leads to a decreased signal-to-noise (S/N) ratio.

Japanese Patent Abstract No JP-A-02307046 discloses a heterodyne method for beam detection. A laser beam is split into a reference beam, which is modulated by an acoustic modulator, and a measuring beam. The beams are not polarised. Radiation scattered from a sample at an angle to the incident measuring beam is mixed with the reference beam and scanning analysis is provided by the sample being mounted on a turntable.

Japanese Patent Abstract No. JP-A-61260211 discloses the detection of defects by separating a light beam into P and S components directed to the same point on a same pile being tested. The light from the sample is returned along the same path and separated into P and S beams for separate detection of the interfering components.

German Patent Specification no. DE-A-3714305 discloses a system for detecting particles on surfaces in which P-polarised and S-polarised beams are incident on the same point on the surface. The beams can be of different frequencies. The beams scattered at an angle to the incident beam are analysed individually to obtain the scattering effect of the surface.

United States Patent Specification No. US-A-4710026 relates to position detection equipment for a semiconductor wafer, a photomask or the like which equipment uses a diffraction grating. It discloses means for providing a predetermined frequency difference between two light beams and generating an optical beat with respect to interference between first and second diffracted light beams, the beams having been diffracted by a diffraction grating formed on a substrate. Means are provided which detect the phase difference between the optical beat and reference signal having a frequency corresponding to the frequency difference between the two light beams so that the position of the substrate can be detected on the basis of the phase difference in accordance with an optical heterodyne interference method.

It is accordingly a concern of the present invention to provide an inspection method or apparatus by which even very small particles or defects on a surface can be detected with a good S/N ratio.

It is another concern of the present invention to provide a method or apparatus for manufacture of microdevices such as semiconductor devices, using such an inspection method.

In accordance with an aspect of the present invention, there is provided an inspection method as set out in claim 1.

In accordance with a second aspect of the invention there is provided an inspection system as set out in claim 8.

These and other features and advantages of the present invention will become more apparent upon a consideration of the following description of the preferred embodiments of the present invention taken in conjunction with the accompanying drawings.

BRIEF DESCRIPTION OF THE DRAWINGS

Figure 1 is a schematic side view of a first apparatus shown for explanatory purposes.

Figure 2 is a schematic plan view of the Figure 1 apparatus.

Figure 3 is a schematic view for explaining generation of scattered light from the surface being inspected.

Figure 4 is a schematic perspective view of a second apparatus.

Figure 5 is a schematic front view of the second apparatus.

Figure 6 is a schematic side view of the second apparatus.

Figure 7 is a schematic plan view of the second apparatus.

Figure 8 is a schematic view for explaining the function of an aperture of the second apparatus.

Figure 9 is a schematic view for explaining the function of the aperture of the second apparatus.

Figure 10 is a schematic perspective view of a third apparatus.

Figure 11 is a schematic perspective view of a fourth apparatus.

Figure 12 is a schematic perspective view of a fifth apparatus.

Figure 13 is an enlarged view of a light scattering structure used in the fifth apparatus.

Figure 14 is a schematic perspective view of a sixth apparatus.

Figure 15 is a schematic view of a seventh apparatus.

Figures 16A and 16B are schematic views each for explaining the direction of detection for scattered light , according to the present invention.

Figure 17 is a schematic and diagrammatic view of an eighth apparatus which is applied to a semiconductor device manufacturing system.

Figure 18 is a schematic and diagrammatic view of a ninth apparatus which is applied to an original cleaning and inspection system.

Figure 19 is a schematic view of a known type inspection apparatus.

PARTICULAR DESCRIPTION

Apparatus 1

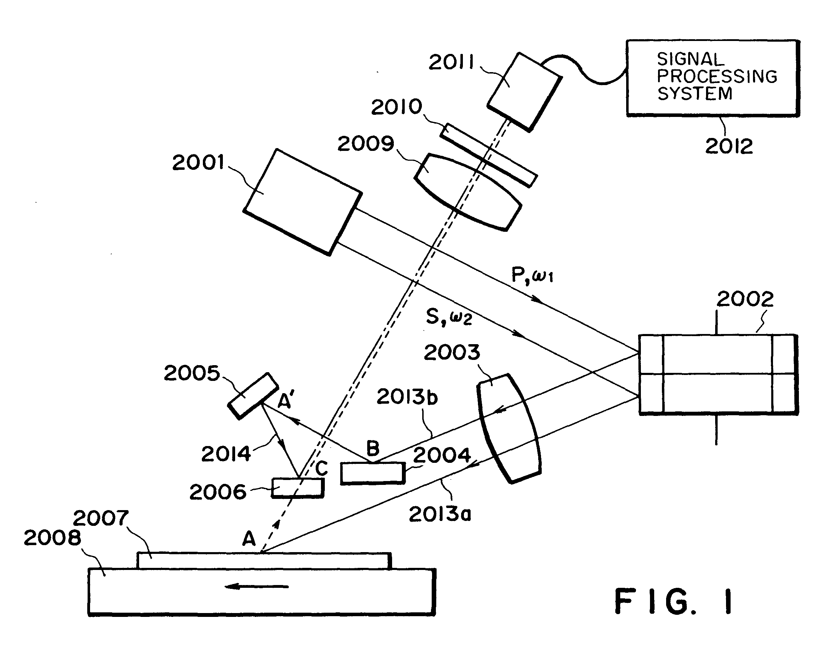

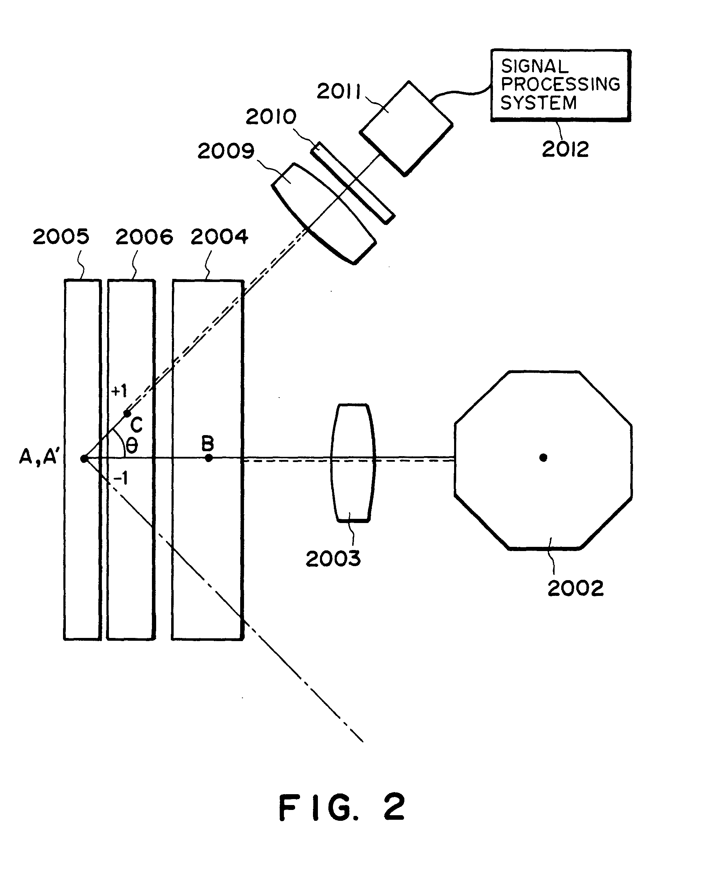

Figures 1 and 2 show for explanatory purposes the structure of a first inspection apparatus wherein Figure 1 is a side view and Figure 2 is a top plan view. In these drawings, denoted at 2001 is a light source device for producing two parallel laser beams having different wavelengths and different polarization directions. Denoted at 2002 is a polygonal mirror and denoted at 2003 is an f-θ lens system, which cooperate with each other to provide a scanning optical system for scanningly deflecting the laser beams from the light source device 2001. Denoted at 2004 is a mirror, denoted at 2005 is a diffraction grating and denoted at 2006 is a half mirror for combining scattered light from the surface, being inspected, and a reference light from the diffraction grating 2005. These elements 2004 - 2006 each has an elongated shape corresponding to the scan region. Denoted at 2007 is the surface to be inspected and, in this example, this is the surface of an original (reticle or photomask) on which a circuit pattern of a semiconductor device or devices is formed. Denoted at 2008 is a stage for carrying thereon and moving the original in a predetermined direction as denoted by an arrow in the drawing. Denoted at 2009 is a condensing lens for collecting scattered light, denoted at 2010 is a polarization plate for transmitting only light of a predetermined polarization component (P-polarized component, in this example), and denoted at 2011 is a photoelectric detector (photo-multiplier) for detecting interference light. The elements 2009 - 2011 cooperate with each other to provide a detection optical system. Denoted at 2012 is a signal processing system for discriminating the state of the surface, being examined, on the basis of the output of the photoelectric detector 2011.

The light source device 2001 produces a P-polarized laser beam of a frequency $w_1$ and an S-polarized laser beam of a frequency $w_2$, directed in parallel to each other. More specifically, it is arranged so that a dual-frequency laser beam from a dual-frequency Zeeman laser light source, as having a predetermined frequency difference and having orthogonally intersecting directions of polarization, is separated into a P-polarized laser and an S-polarized laser by means of a polarization beam splitter, for example. Alternatively, one or two acousto-optic devices may be used to frequency-modulate two laser beams. As a further alternative, injection current to a semiconductor laser may be controlled to provide laser beams of two different frequencies.

The two parallel laser beams produced by the light source device 2001 are directed to the scanning optical system which comprises the polygonal mirror 2002 and the f-θ lens system 2003. Of these two laser beams, one 2013a (S-polarized light with a frequency $w_2$) is projected on a point A on the surface 2007 being examined, to scan the surface one-dimensionally in a particular direction. Simultaneously, the surface 2007 is displaced by the stage 2008 in a direction perpendicular to the particular direction. As a result, the surface 2007 is scanned two-dimensionally.

When the light 2013a is incident on the surface 2007 and if there is a particle or defect or, alternatively, a circuit pattern at the position being irradiated, the S-polarized light 2013a is depolarized by such particle or defect to produce scattered light (P-polarized light and S-polarized light) or the light 2013a is scattered by the circuit pattern to produce scattered light (mainly consisting of S-polarized light). Here, the reason why the light is depolarized by a particle or defect may be that: generally, the surface of such a particle or defect is rough and, therefore, polarization is disturbed when the light is irregularly reflected and scattered by that surface such that a polarization component different from the plane of polarization of the light as the same is inputted is generated. As compared therewith, if the light is scattered by an object such as a circuit pattern, having a relatively even and flat surface, depolarization is small.

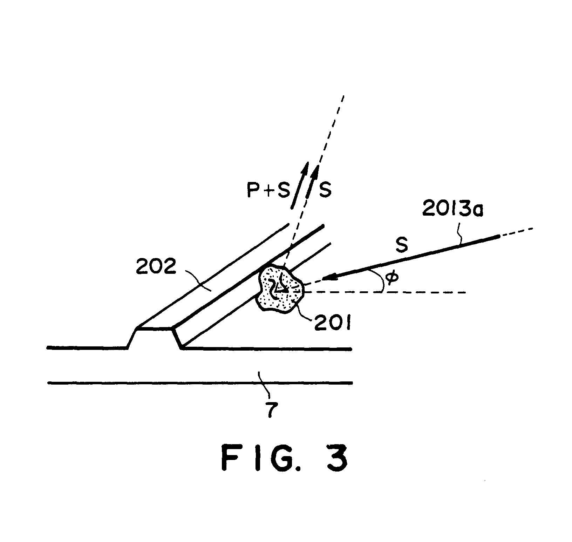

Figure 3 is an enlarged view, illustrating presence of a particle and a circuit pattern in the neighbourhood of a scanning spot. Denoted at 201 is a particle of a size of about 0.3 micron, adhered to the surface 7. Denoted at 202 is a circuit pattern. As the S-polarized light 2013a is projected on the surface with an angle of incidence of Ø, it is depolarized by the particle 201 and, thus, scattered light of P- and S-polarized components is produced isotropically from the particle 201. Also, non-depolarized (or little depolarized) scattered diffraction light of S-polarization is produced from the circuit pattern 202. Thus, by arranging the system so that the direction for the detection of the scattered light is placed in such direction along which no diffraction light comes from the circuit pattern 202, it is possible to improve the S/N ratio. This direction for the detection of scattered light may be determined as desired on the basis of the positional relationship among the mirror 2004, the diffraction grating 2005 and the half mirror 2006 as well as the pitch of the diffraction grating 2005 (to be described later). In this first apparatus, the system is arranged so as to detect the scattered light being scattered backwardly and sidewardly of the input light 2013a.

Referring back to Figures 1 and 2, the other 2013b (P-polarized light with a frequency $w_1$) of the light beams scanningly deflected by the scanning optical system, is reflected at a point B on the mirror 2004 and is directed to a point A' on the diffraction grating 2005. Then, from the point A', diffraction light is produced at a predetermined diffraction angle. This diffraction angle θ is determined in accordance with the following equation:

$$P\sin\theta = \pm m\lambda$$

where P is the pitch of the diffraction grating, θ is the diffraction angle, λ is the wavelength and m is the order of diffraction.

In this first apparatus, of the diffraction light emanating from the diffraction grating 5 at a diffraction angle θ, positive first-order diffraction light 2014 (frequency $w_1$) is used as a reference light. This positive first-order diffraction light 2014 is reflected at a point C on the half mirror 2006 toward the detection optical system. Here, the point A' of light incidence upon the diffraction grating 2005 and the point A of light incidence upon the surface 2007 are in an optically conjugate relationship with each other. As a result, both the positive first-order diffraction light (reference light) 2014 from the diffraction grating 2005 and the scattered light from the surface 2007, being examined, are collected by the condensing lens 2009. Then, by means of the polarization plate 2010, only the P-polarized component is selected. Thus, due to heterodyne interference between the reference light (P-polarized light with a frequency $w_1$) and the light wave (P-polarized light with a frequency $w_2$) among the scattered light and being depolarized by the particle or defect, a beat of a frequency $\Delta w$ (= $|w_2-w_1|$) is produced. This beat is detected as a beat signal by the photoelectric detector 2011 and, on the basis of which, the particle or defect is detected by the signal processing system 2012 while being discriminated from a circuit pattern.

The particle/defect detection in this first apparatus is based on the fact that: such component of the scattered light that cam be transformed into a beat signal through optical heterodyne interference is only the P-polarized light component which is the resultant of depolarization; and even if scattered light from a circuit pattern is contained, it mainly consists of an S-polarized light component which does not participate in the optical heterodyne interference and thus can not be transformed into a beat signal by the photoelectric detector 2011. This means that only the scattered light from a particle or defect is detected as a beat signal and that, even if there is scattered light from a circuit pattern, it is not transformed into such a beat signal (even if it is so transformed, the produced beat is very low). In this manner, the inspection system of this embodiment assures a very high sensitivity and a very high S/N ratio for the particle/defect inspection.

It is to be noted here that the optical structure as described hereinbefore may be modified so that the relationship between lights of S-polarization and P-polarization is inverted. Similar particle or fault detection is possible with such a modified structure.

Apparatus 2

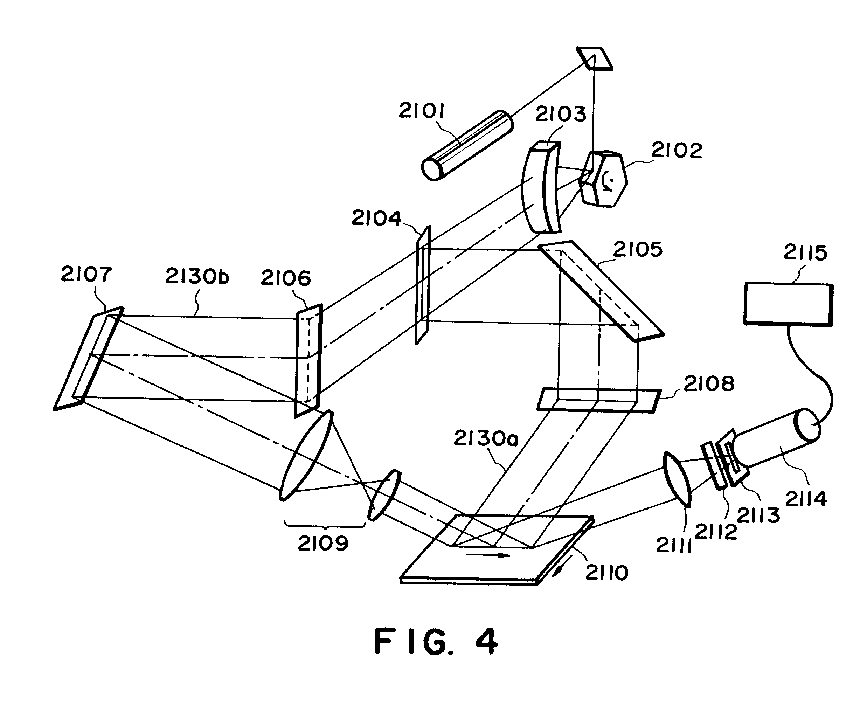

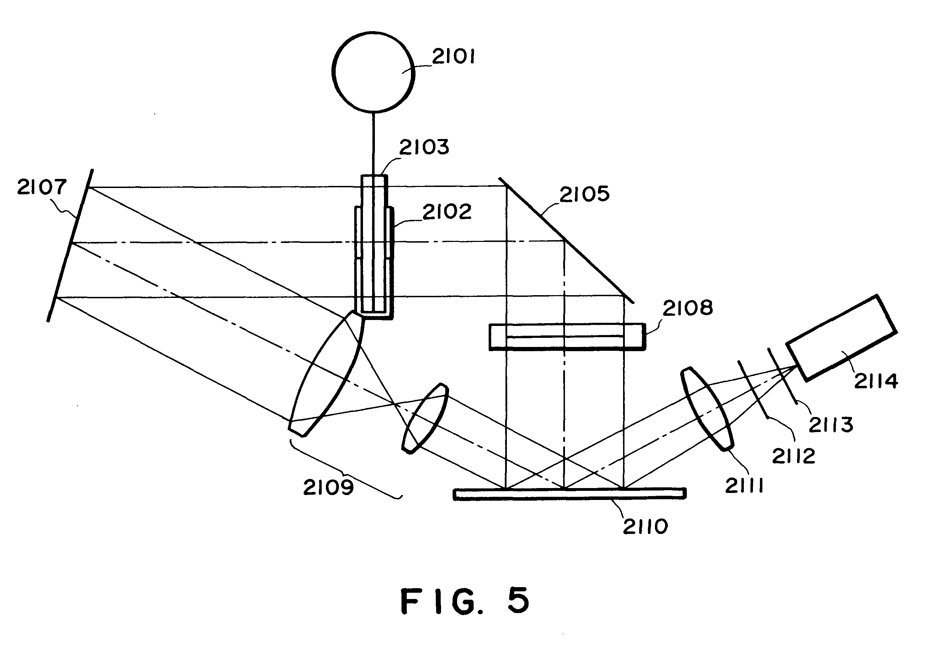

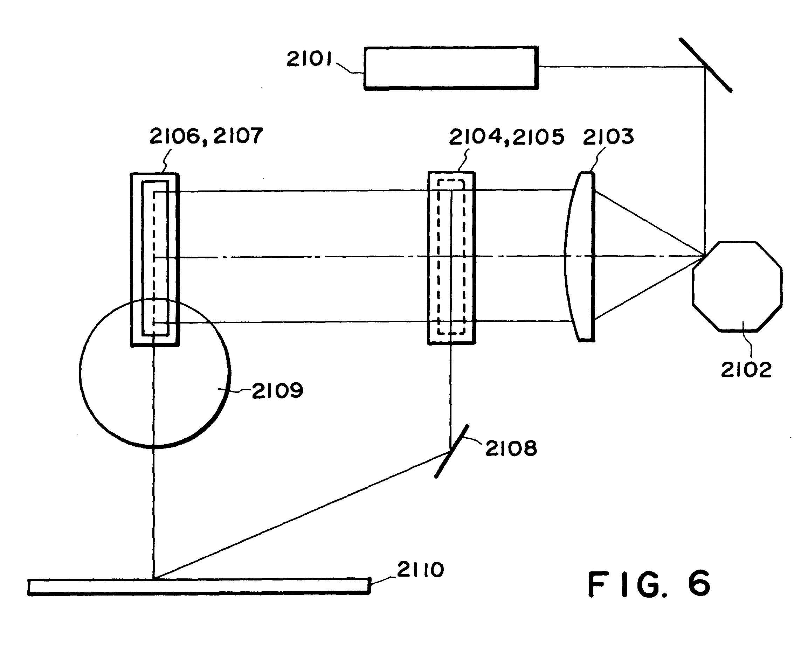

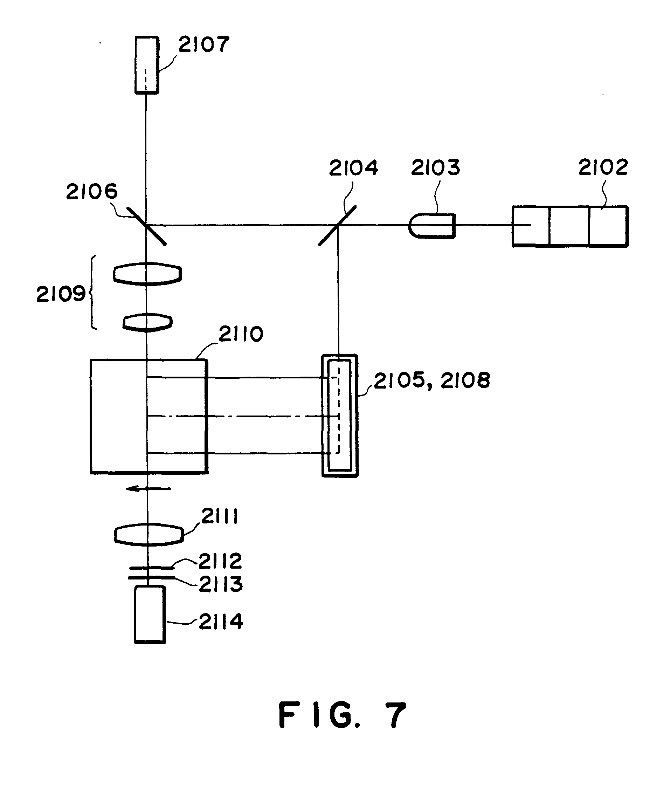

A second apparatus will be described with reference to Figures 4 - 7, wherein Figure 4 is a perspective view showing the general structure of the second embodiment and Figures 5, 6 and 7 are a front view, a side view and a plan view of the second embodiment, respectively.

Denoted at 2101 is a light source device which, like the light source device 2001 of the nineteenth embodiment, produces a P-polarized laser beam of a frequency $w_1$ and an S-polarized laser beam of a frequency $w_2$, superposed one upon another on the same optical axis. Denoted at 2102 is a polygonal mirror and denoted at 2103 is an f-θ lens system, which cooperate with each other to provide a scanning optical system. Denoted at 2104 is a polarization beam splitter and denoted at 2105, 2106, 2107 and 2108 are mirrors, respectively, each having an elongated shape corresponding to the scan range. Denoted at 2109 is an afocal converter for changing the width of scan by the scanning light. Denoted at 2110 is the surface to be inspected, and this surface can be displaced in a direction intersecting the direction of scan by the scanning light. Denoted at 2111 is a condensing lens for collecting the combined wave of (i) scattered light, from the surface 2110 being examined, of the light 2130a scanningly deflected through the mirror 2108 and scanning the surface 2110 and (ii) reference light from the afocal converter 2109 and reflectively scattered by the surface 2110. Denoted at 2112 is a polarization plate for registering the plane of polarization, for the purpose of detection of a heterodyne signal. Denoted at 2113 is an aperture having a rectangular opening corresponding to the scan range, for suppressing DC components of the heterodyne signal. Denoted at 2114 is a photoelectric detector (photo-multiplier), and denoted at 2115 is a signal processing system.

The laser beam from the light source device 2101 is scanningly deflected by the scanning optical system which comprises the polygonal mirror 2102 and the f-θ lens system 2103. The polarization beam splitter 2104 transmits P-polarized light component (frequency $w_1$) and reflects S-polarized light component (frequency $w_2$), and thus it separates the laser beam into two beams. Of these two laser beams, the reflected light 2130a is then deflected by two mirrors 2105 and 2108, such that it is projected on the surface 2110, to be inspected, along a predetermined direction to scan the same one-dimensionally.

On the other hand, the light 2130b scanningly deflected by the scanning optical system and then transmitted through the polarization beam splitter 2104, is deflected by two mirrors 2106 and 2107 toward the afocal converter 2109. The afocal converter reduces the scan range of the light 2130b and, additionally, reverse the direction of scan. The resultant light is projected on the surface 2110, along a direction different from the direction of projection of the light 2130a (perpendicular thereto as viewed from the above). Here, under the influence of the afocal converter 2109, the light 2130a and the light 2130b are superposed one upon another on the surface 2110, such that at any moment during the scanning period these two lights scans the same point on the surface 2110.

When the light 2130a (S-polarized light with a frequency $w_2$) is incident on the surface 2110 and if there is a particle or defect or, alternatively, a circuit pattern at the position being irradiated, the S-polarized light 130a (frequency $w_2$) is depolarized by such particle or defect to produce scattered light (P-polarized light and S-polarized light) or the light 2130a is scattered by the circuit pattern to produce scattered light (mainly consisting of S-polarized light). Here, the reason why the light is depolarized by a particle or defect may be that: generally, the surface of such a particle or defect is rough and, therefore, polarization is disturbed when the light is irregularly reflected and scattered by that surface such that a polarization component different from the plane of polarization of the light as the same is inputted is generated. As compared therewith, if the light is scattered by an object such as a circuit pattern, having a relatively even and flat surface, depolarization is small.

The detection optical system which comprises the condensing lens 2111 is disposed in the direction of zeroth order light caused by the light 130b (P-polarized light of a frequency $w_1$) projected to the surface 2110. Also, the light 2130a (S-polarized light of frequency $w_2$) is incident on the same point upon the surface 2110, but in a direction different (by 90 deg.) from the direction of the light 2130b. As a result, there are produced (from the same point on the surface 2110) a reference light (substantially of P-polarization) from the light 2130b and containing zeroth order light as well as sideward (90 deg.) scattered light (S-polarization and P-polarization) from the light 2130a. Both of the thus produced lights enter the condensing lens 2111. Then, by means of the polarization plate 2112, only the P-polarized component is selected. Thus, due to heterodyne interference between the reference light (P-polarized light with a frequency $w_1$) and the light wave (P-polarized light with a frequency $w_2$) among the scattered light from the light 2130a and being depolarized by the particle or defect, a beat of a frequency $\Delta w$ (= $|w_2-w_1|$) is produced. This beat is detected as a beat signal by the photoelectric detector 2114 and, on the basis of which, the particle or defect is detected by the signal processing system 2115 while being discriminated from a circuit pattern in the same manner as the first embodiment.

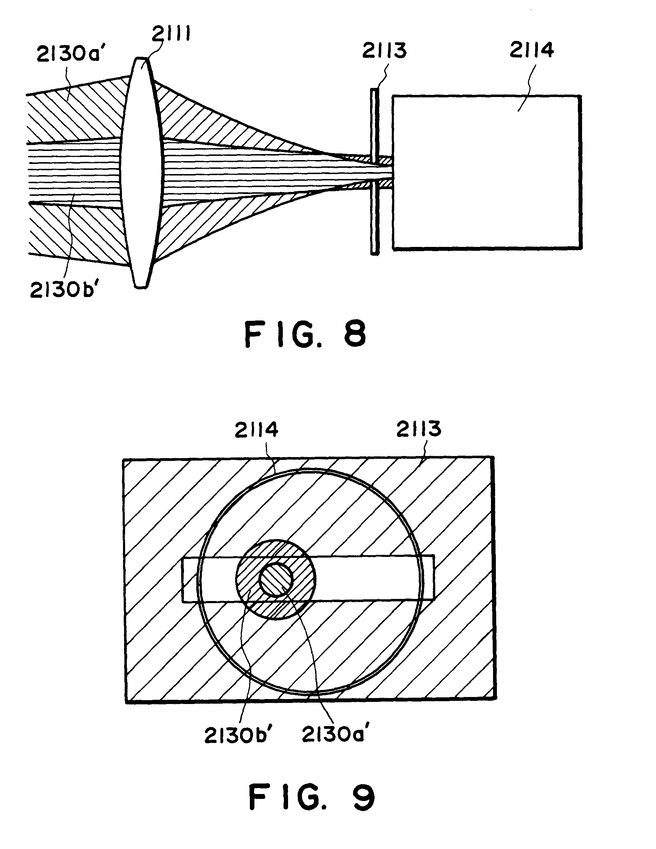

Figures 8 and 9 are schematic views for explaining the function of an aperture 2113 which is disposed between the condensing lens 2111 and the photoelectric detector 2114. Figure 8 is a side view and Figure 9 is a view as seen on the optical axis. The scattered light produced laterally widely as a result of irradiation of a particle or defect upon the surface, being examined, with the light 2130a is projected upon the whole diameter of the condensing lens 2111, as depicted at 2130a'. On the other hand, since the light 2130b is reflectively scattered by the surface being examined, it is not diverged so widely and is projected upon a limited portion of the diameter of the condensing lens 2111, as depicted at 2130b'. Thus, they have different numerical apertures (NAs). Consequently, on the detection surface (photoelectric detection surface) of the photoelectric detector 2114 upon which these lights are converged, the converged lights have different light spot diameters. This leads to that, in a portion other than the overlapping portion (interfering portion) of the converged light spots, these lights do not interfere with each other and, as a result of which the AC component of the beat signal is relatively reduced. In consideration of such an inconvenience, in the present embodiment an aperture 2113 is disposed along the scan range so as to block an unnecessary portion of the reference light 2130b' to ensure an increase in the S/N ratio.

While this second apparatus is arranged so as to detect scattered light, scattered sidewardly by 90 deg., in accordance with the invention the apparatus may be modified so as to detect light scattered forwardly and sidewardly as defined in claim 1.

Apparatus 3

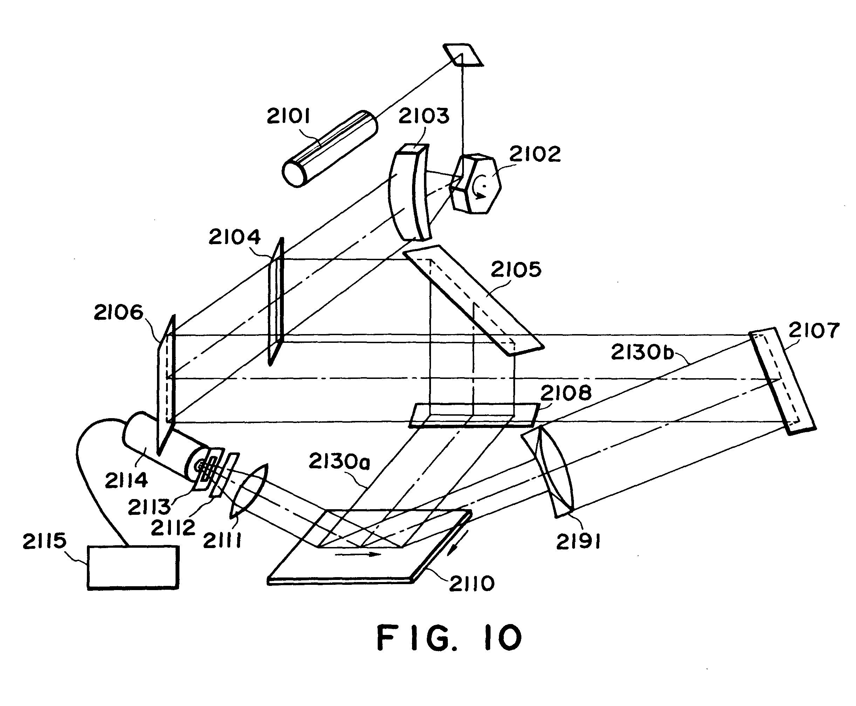

Figure 10 shows a third apparatus which corresponds to a partially modified form of the second embodiment. The principle of detection is basically the same as that of the second apparatus. In the structure of Figure 10, the position of the mirror 2107 with respect to the optical system shown in Figure 46 is changed to widen the flexibility in respect to the placement of the afocal converter 2191. Since in the afocal converter 2191 of this embodiment it is not necessary to reverse the scan direction, it comprises a combination of a convex lens and a concave lens, rather than a combination of two convex lenses such as shown in Figure 4.

Apparatus 4

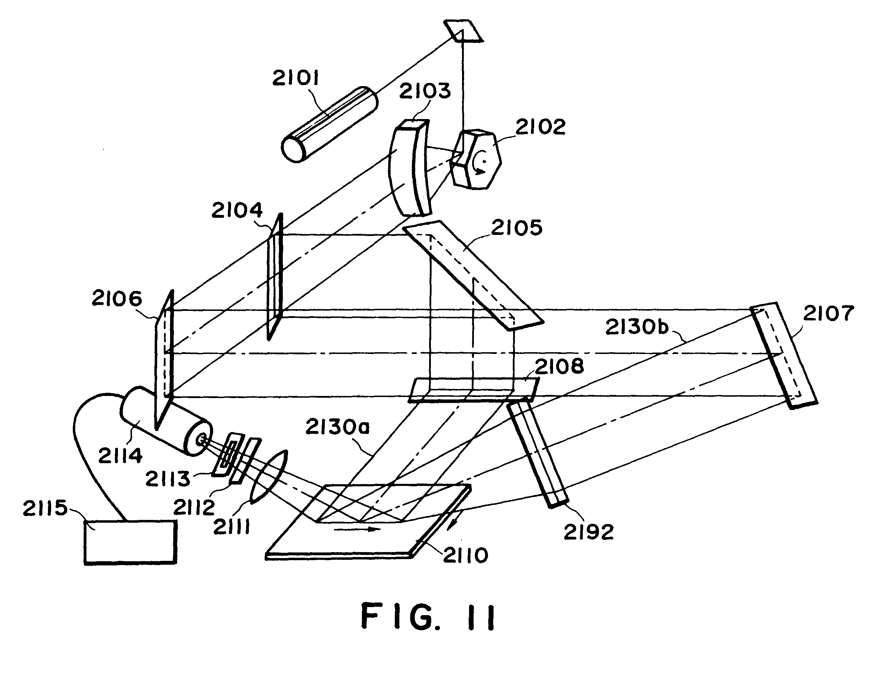

Figure 11 shows a fourth apparatus which corresponds to a modified form of the third apparatus. In this a hologram 2192 is used in place of the afocal converter 2191 of Figure 52. The hologram 2192 is a physical optic element having a function for transforming an input wavefront of a received input light into a predetermined wavefront, and the hologram 2192 is disposed so that light is continuously converged on the locus of scan on the surface 2110. This assures substantially the same advantageous results as attainable with the third embodiment.

Apparatus 5

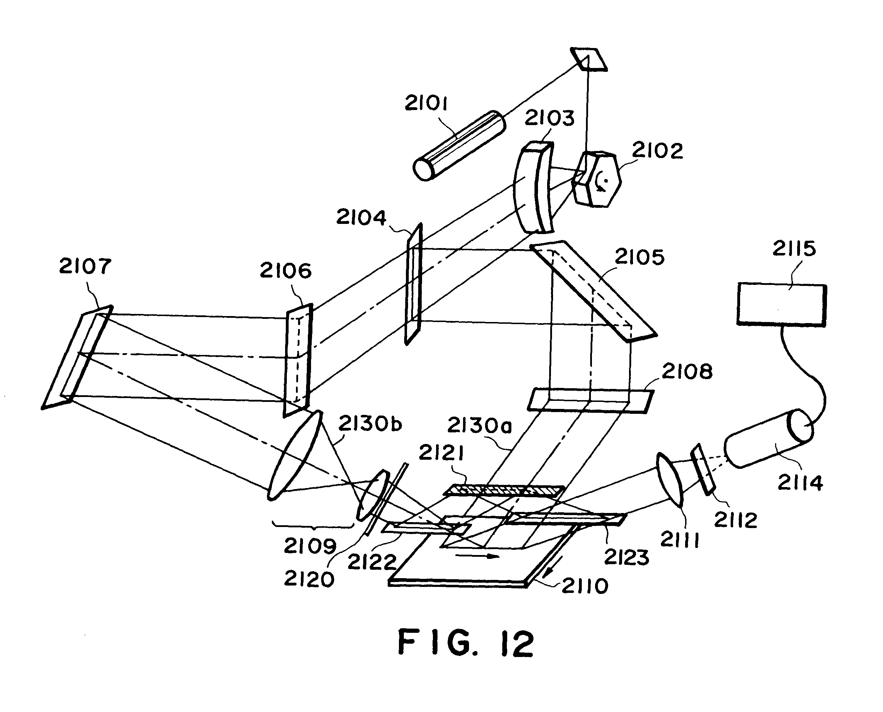

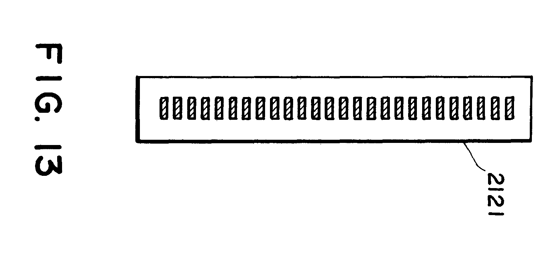

Figure 12 shows a fifth apparatus, and like numerals as of Figure 4 are assigned to corresponding elements. In this apparatus the light 2130b is not projected on the surface to be examined but is directly combined with the scattered light. Denoted in the drawing at 2120 is a $\lambda/2$ plate (polarization setting means), denoted at 2121 is a light scattering structure, denoted at 2122 is a mirror, and denoted at 2123 is a half mirror. The light 2130b passed through the afocal converter 2109 goes through the $\lambda/2$ plate 2120, by which the direction of polarization thereof is changed and then set to a desirable direction. This polarization direction is coordinated with that of the polarization plate 2112. The light from the $\lambda/2$ plate is reflected by the mirror 2122 and is projected on the scattering structure 2121. The scattering structure 2121 has such arrangement, as shown in Figure 13, for example, wherein a glass substrate is patterned with a plurality of patterns of Cr material, for example, in the manner that their edges lie in the scan direction. It serves to produce scattered light, widely in predetermined directions. The light scattered by the pattern of the scattering structure 2121 enters the half mirror 2123. On the other hand, the sideward scattered light from a particle, produced as a result of irradiation with the light 2130a, also enters the half mirror 2123. Thus, by the half mirror, these lights are combined with each other. Here, the point of convergence of the light 130a, impinging on the surface being examined, and the point of irradiation on the scattering structure 2121 being irradiated with the light 2130b are in an optically conjugate relationship with each other with respect to the half mirror 2123.

Since in this apparatus the light which then provides the reference light is widely scattered by the scattering structure 2121, there is only a small difference between the light spot diameters of the two lights as having been described with reference to Figures 8 and 9. Thus, even with the omission of the aperture 113, it is possible to produce a beat signal of good quality.

Apparatus 6

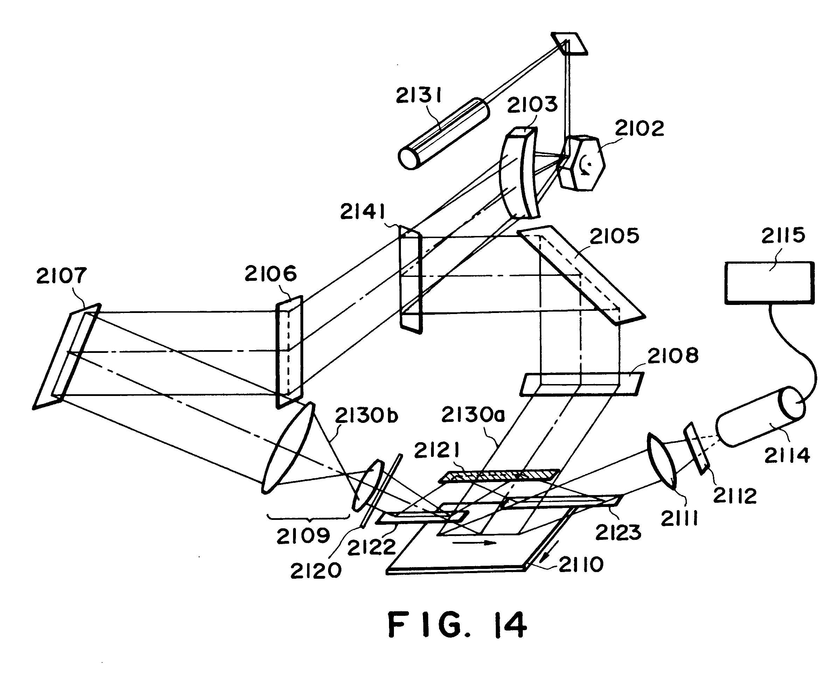

Figure 14 shows a sixth apparatus which corresponds to a modified form of the fifth apparatus. As compared with the preceding apparatuses, this embodiment uses a light source device 2131 which produces a P-polarized laser beam of a frequency $w_1$ and an S-polarized laser beam of a frequency $w_2$ and which emits them separately in parallel to each other, rather than in the form of a single beam. These two parallel light beams are scanned by a scanning optical system, and only one of them (i.e., only the S-polarized light of frequency $w_2$) is reflected by a reflection mirror 2141. The structure and function of the remaining portion of the inspection system are essentially the same as those of the apparatus of Figure 12. Since in this apparatus it is not necessary to use a polarization beam splitter of elongated shape which is generally expensive, the cost of the inspection system can be reduced significantly.

Apparatus 7

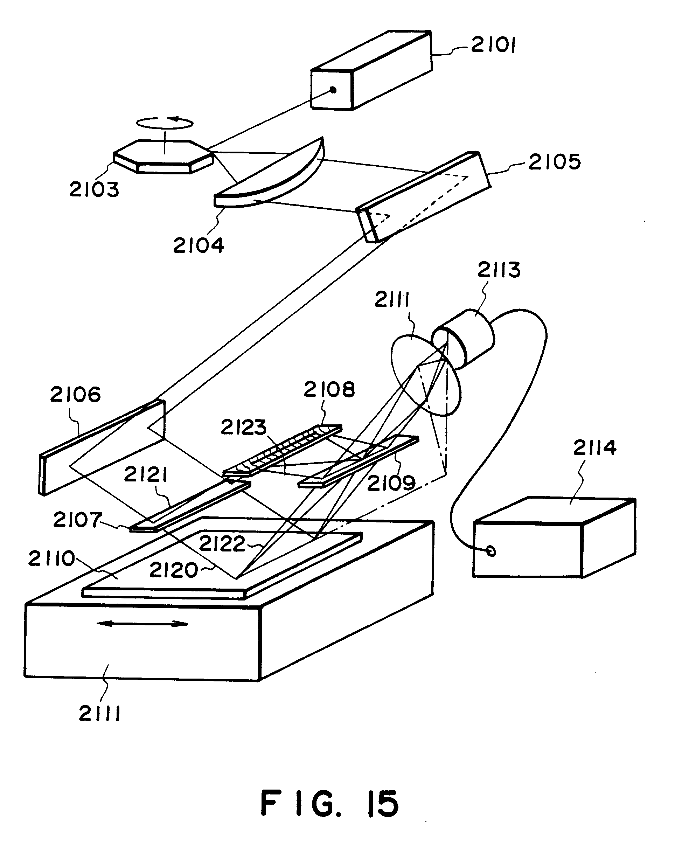

Figure 15 shows a seventh apparatus.

In the drawing, denoted at 2101 is a dual-frequency laser source such as a Zeeman laser, a semiconductor laser or an optical system using acousto-optic means. Denoted at 2103 is a scanning mirror; at 2104 is an f-9 lens; at 2105 and 2106 are reflection mirrors; at 2107 is a polarization beam splitter; at 2108 is a diffraction grating; at 2109 is a half mirror; at 2110 is the surface to be inspected; at 15 is a scanning stage; at 2112 is a condensing lens; at 2113 is a photoelectric detector; and at 2114 is a beat signal processing system.

Laser beam from the dual-frequency laser source 2101 are directed by a scanning optical system comprising the scanning mirror 2103 and the f-$\theta$ lens 2104, whereby it is scanningly deflected. Then, it goes via the mirrors 2105 and 2106 and, by means of the polarization beam splitter 2107, it is subsequently divided into an S-polarized laser beam (shift frequency $\omega$) 2020 and a P-polarized laser beam (shift frequency $\omega+\Delta\omega$) 2121. The divided S-polarized laser beam 2120 is converged into a spot upon the surface 2110 to be inspected. Scattered rays from a particle/fault or a circuit pattern within the spot, providing side-scattered light 2122, are collected, after being passed through the half mirror 2109, by the condensing lens 2111 which is disposed sideways by approx. 90 deg. of the direction of incidence of the S-polarized laser beam 2120. On the other hand, the P-polarized laser beam 2121 is converged upon the diffraction grating 2108, by which diffraction light is produced. Here, the system is so arranged that, of the produced diffraction light, first order diffraction light 2123 is directed to the half mirror 2109. The half mirror 2109 then combines the first order diffraction light 2123 and the side scattered light 2122. The diffraction grating 2108 is so designed that it produces first order diffraction light sideways by approx. 90 deg. to the incident light such that, in accordance with the position of a light spot being displaced by the scanning optical system, the first order diffraction light is continuously combined with the side scattered light 2122 by the half mirror 2109. The P-polarized light component (being depolarized by a particle or fault) contained in the side scattered light 2122 and the first order diffraction light (P-polarized light component) from the diffraction grating 2108, having been combined by the half mirror 2109, are imaged through the condensing optical lens 2111 upon the sensing surface of the photoelectric detector 2113 and they cause optical heterodyne interference. The resultant signal is processed by the beat signal processing system 2114.

While in this seventh apparatus the sensing surface of the photoelectric detector 2113 is placed in a conjugate relationship with the spot on the surface 2110 being inspected, it may be disposed upon a pupil plane. Further, the relationship between the P-polarized light and the S-polarized light may be inverted.

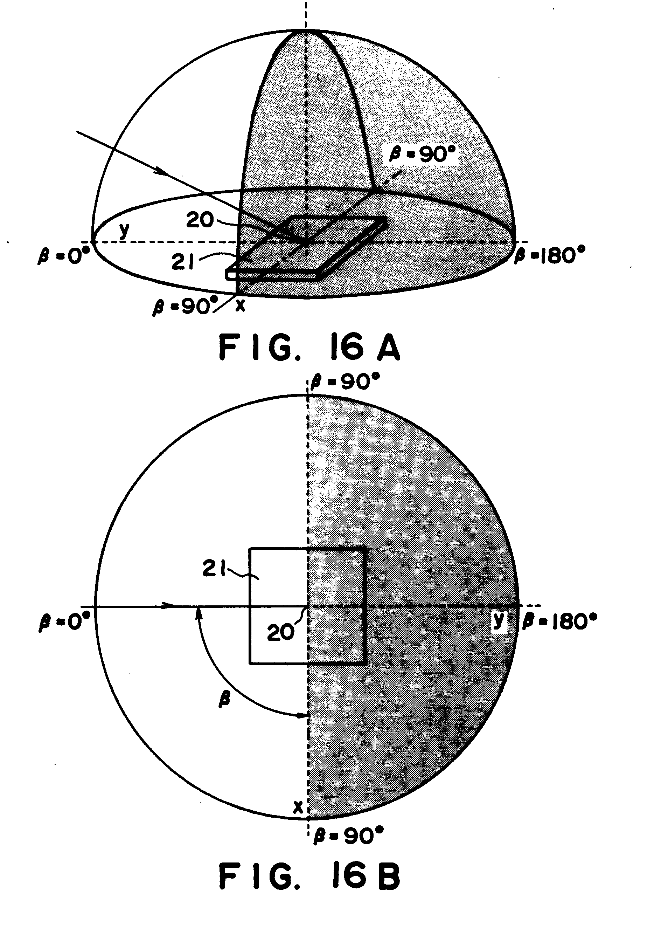

The first to seventh apparatuses described hereinbefore are arranged to detect scattered light which advances sideways with respect to incident or input light. The inventors have examined other detection angles in relation to a particle of a size of about 0.3 micron. From the results, it has been found that a high detection sensitivity is obtainable if the photoelectric detector is so disposed that the angle $\beta$ defined between orthogonal projection lines, being defined by projecting upon the surface to be inspected the input light and the light incident on the photoelectric detector, is within a range of 90 - 180 deg , in other words to dispose the photoelectric detector with in a range as depicted by hatching in Figure 16A or 16B provided that the angle as defined is within the given range.

Apparatus 8

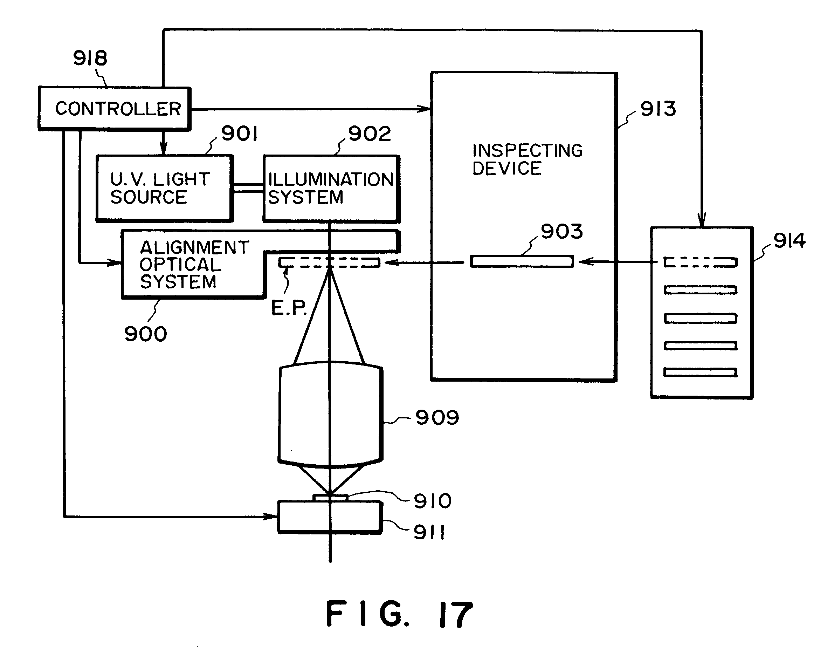

Figure 17 shows a semiconductor device manufacturing system for printing a circuit pattern of an original such as a reticle or photomask upon a silicon wafer. Generally stating, this system comprises an exposure apparatus, an original storing device, an original inspecting device and a controller, all being placed in a clean room.

Denoted at 901 is a deep ultraviolet light source such as an excimer laser, for example, and denoted at 902 is an illumination system unit for illuminating an original, held at an exposure position (E.P.), simultaneously (whole surface illumination) from the above and with a predetermined numerical aperture (NA). Denoted at 909 is an ultra-high-resolution lens system (or mirror system) for transferring the circuit pattern formed on the original onto a silicon wafer 910. Upon printing, the wafer is shifted one-shot by one-shot with stepwise motion of a movable stage 911 so that repeated exposures are made thereto. Denoted at 900 is an alignment optical system for aligning the original and the wafer prior to the exposure operation. It includes at least one original observing microscope system. These elements constitute the exposure apparatus.

On the other hand, denoted at 914 is the original storing device for accommodating therein a plurality of originals. Denoted at 913 is the original inspecting device which has the structure according to any one of the preceding apparatuses. The inspecting device 913 serves to execute particle inspection to a selected one of the originals, taken out of the storing device 914, before it is placed at the exposure station EP. The principle and manner of particle inspection is the same as that of the corresponding apparatus. Controller 918 serves to control the sequence of the while system and, as an example, it controls the operation of the storing device 914 and the inspecting device 913 as well as the alignment and exposure operation and wafer stepwise operation which are basic operations of the exposure apparatus.

A semiconductor device manufacturing process using the system of the present apparatus will now be explained. First, an original to be used is taken out of the original storing device 914 and it is placed in the inspecting device 913. Then, particle inspection to this original is executed through the inspecting device. If, as a result of inspection, it is discriminated that no particle is present on the original, the original is then placed at the exposure station EP in the exposure apparatus. Subsequently, a silicon wafer 910 which is an article to be exposed is placed on the movable stage 911. Then, while moving the movable stage 911 stepwise and shifting the wafer one-shot by one-shot in accordance with the step-and-repeat method, the pattern of the original is projected in a reduced scale on different zones of the silicon wafer to expose them. After the exposure process to one wafer is completed, this wafer is off-loaded and a new silicon wafer is loaded, and step-and-repeat exposures of it to the pattern of the original are repeated in the same manner.

The "exposed" wafer whose exposure process is completed, is subjected to a developing process, an etching process and so on through respective devices provided separately from the illustrated system. After this, it is subjected to assembling processes such as dicing, wire bonding, packaging and so on, whereby semiconductor devices are finished.

Apparatus 9

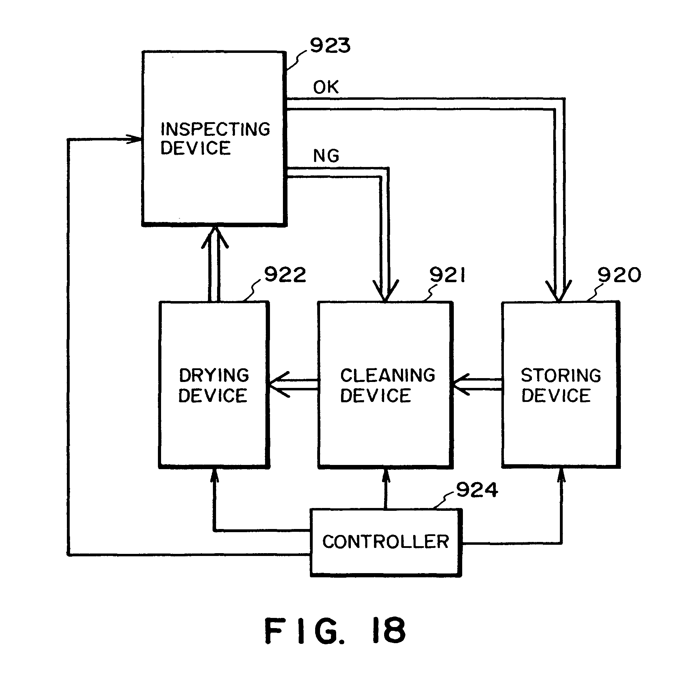

Figure 18 shows a cleaning and inspecting system for manufacture of semiconductor devices. Generally stating, the system comprises an original storing device, a cleaning device, a drying device, an inspecting device and a controller, all being placed in a clean room.

Denoted at 920 is ah original storing device for storing therein some originals. It is operable to selectively supply an original to be cleaned. Denoted at 921 is a cleaning device for cleaning an original by using pure water. Denoted at 922 is a drying device for drying a cleaned original. Denoted at 923 is an original inspecting device which is arranged in accordance with any one of the preceding embodiments and which serves to execute particle inspection to a cleaned original. Denoted at 924 is a controller which serves to execute the sequence control to the system as a whole.

The operation will be explained. First, an original to be cleaned is taken out of the original storing device 920 and it is moved into the cleaning device 921. After the cleaning in the cleaning device 921, the cleaned original is moved into the drying device 922 and is dried. After it is dried, it is moved into the inspecting device 923. In this inspecting device, any foreign particle on this original is inspected in accordance with the method of any one of the embodiments described hereinbefore. If as a result of inspection any particle is not detected, the original is moved back into the storing device 920. If any particle is detected, the original is moved back to the cleaning device 921 and, after repetition of the cleaning and drying operation, it is inspected again. This is repeated until particles are totally removed, and a completely cleaned original is moved back into the storing device 920.

Subsequently, such a cleaned original is placed in an exposure apparatus and the printing of a circuit pattern of the original on a silicon wafer is executed, for manufacture of semiconductor devices.

While the invention has been described with reference to the structures disclosed herein, it is not confined to the details set forth and this application is intended to cover such modifications or changes as may come within the purposes of the improvements or the scope of the following claims.

**Claims**

1. An inspection method comprising:

   forming a first beam of first polarization and of first wavelength, and a second beam of second polarization, different from the first polarization, and of a second wavelength different from the first wavelength;
   deflecting the first and second beams in a scanning manner;
   illuminating a surface to be inspected with at least the deflected and scanned first beam; and detecting a heterodyne interference beam resulting from heterodyne interference between the second beam and a beam scattered from the surface illuminated with the first beam, the scattered beam having its polarisation changed from the first polarisation by scattering caused by a foreign particle, the scattered beam being located within a quadrant of a sphere the base of which is parallel to the plane of the surface being inspected, the centre of the said sphere being the point where the first beam strikes the surface being inspected, and there being an obtuse angle between the incident inspection beam and the scattered beam in the plane of the surface being inspected.

2. A method according to claim 1, wherein said detecting step comprises using a diffraction grating for combining the second beam with the scattered beam.

**3.** A method according to claim 1 or claim 2, wherein said illuminating step comprises scanningly illuminating the same position on the surface, with both the first and second beams in mutually different incidence directions.

**4.** A method according to any preceding claim, wherein the surface to be inspected is the surface of a reticle or a mask having a pattern, wherein inspection is made to detect any foreign particle on the surface while distinguishing the same from the pattern.

**5.** A method according to any preceding claim, wherein the interference beam is produced while the second beam is not directed to the surface being inspected.

**6.** A method according to any one of the preceding claims and including the subsequent step of projecting a pattern onto a waver to expose the wafer, and then carrying out inspection of the waver.

**7.** A method according to claim 6 and including the step of cleaning an exposed wafer.

**8.** An inspection system arranged to perform an inspection method as recited in any one of claims 1 to 4 comprising:

a light source (2001, 2101, 2131) for forming the first and second beams;
a scanning mirror (2102) for scanning the surface to be inspected, with at least the first beam; and
a detector (2011, 2114) for detecting the heterodyne interference beam.

**9.** An apparatus according to claim 8, wherein the light source comprises a laser light source.

**10.** An exposure system for printing a pattern of a mask on a workpiece, **characterised by**:

an inspection apparatus according to either of claims 8 or 9; and
means (901, 909) for projecting the pattern of the mask onto the workpiece (910);

wherein in operation of the system the mask is inspected by said inspection apparatus.

**11.** A cleaning system for cleaning a mask and **characterised by**:

an inspection apparatus as recited in either of claims 8 or 9; and
means (921) for cleaning the surface of the mask;

wherein in operation the mask is inspected by said inspection apparatus.

**Patentansprüche**

**1.** Inspektionsverfahren mit den Schritten

Ausbilden eines ersten Strahles einer ersten Polarisation und einer ersten Wellenlänge sowie eines zweiten Strahles einer von der ersten Polarisation verschiedenen zweiten Polarisation und einer von der ersten Wellenlänge verschiedenen zweiten Wellenlänge;
Ablenken des ersten und des zweiten Strahls in einer abtastenden Weise;
Beleuchten einer zu inspizierenden Oberfläche mit zumindest dem abgelenkten und abtastenden ersten Strahl; und
Erfassen eines aus einer Überlagerungsinterferenz zwischen dem zweiten Strahl und einem von der mit dem ersten Strahl beleuchteten Oberfläche gestreuten Strahl resultierenden Überlagerungsinterferenzstrahl, dabei verändert der gestreute Strahl seine Polarisation von der ersten Polarisation durch Streuung, die durch Fremdpartikel verursacht wird, wobei der gestreute Strahl innerhalb eines Quadranten einer Kugel lokalisiert ist, dessen Basis parallel zu der Ebene der inspizierten Oberfläche ist, und das Zentrum der Kugel der Punkt ist, an dem der erste Strahl auf die inspizierte Oberfläche trifft, dabei liegt ein stumpfer Winkel zwischen dem einfallenden Inspektionsstrahl und dem gestreuten Strahl in der Ebene der inspizierten Oberfläche vor.

**2.** Verfahren nach Anspruch 1, wobei der Erfassungsschritt die Verwendung einer Beugungsgitters für die Kombination des zweiten Strahls mit dem gestreuten Strahl umfasst.

**3.** Verfahren nach Anspruch 1 oder 2, wobei der Beleuchtungsschritt eine abtastende Beleuchtung derselben Stelle auf der Oberfläche umfasst, dabei liegen der erste und der zweite Stahl in zueinander verschiedenen Einfallrichtungen.

**4.** Verfahren nach einem der vorstehenden Ansprüche, wobei die zu inspizierende Oberfläche die Oberfläche einer Messmarkierung oder einer Maske mit einem Muster ist, dabei wird die Inspektion zur Erfassung von Fremdpartikeln auf der Oberfläche ausgeführt, während diese vom Muster unterschieden werden.

**5.** Verfahren nach einem der vorstehenden Ansprüche, wobei der Interferenzstrahl erzeugt wird, während der zweite Strahl nicht auf die inspizierte Oberfläche gerichtet ist.

**6.** Verfahren nach einem der vorstehenden Ansprüche, mit dem nachfolgenden Schritt des Projizierens eines Musters auf einen Wafer zur Belichtung des Wafers, woraufhin die Inspektion des Wafers ausgeführt wird.

**7.** Verfahren nach Anspruch 6, mit dem Schritt des Reinigens eines belichteten Wafers.

**8.** Inspektionssystem, das zur Durchführung eines Inspektionsverfahrens gemäß einem der Ansprüche 1 bis 4 angeordnet ist, mit:

einer Lichtquelle (2001, 2101, 2131) zur Ausbildung des ersten und des zweiten Strahls; einem Abtastspiegel (2102) zum Abtasten der zu inspizierenden Oberfläche mit zumindest dem ersten Strahl; und einer Erfassungseinrichtung (2011, 2114) zum Erfassen des Überlagerungsinterferenzstrahls.

**9.** System nach Anspruch 8, wobei die Lichtquelle eine Laserlichtquelle aufweist.

**10.** Belichtungssystem zum Abbilden eines Musters einer Maske auf einem Werkstück, **gekennzeichnet durch**

ein Inspektionssystem gemäß Anspruch 8 oder 9; und eine Einrichtung (901, 909) zum Projizieren des Musters der Maske auf das Werkstück (910);

wobei beim Betreiben des Systems die Maske **durch** das Inspektionssystem inspiziert wird.

**11.** Reinigungssystem zum Reinigen einer Maske, **gekennzeichnet durch**

ein Inspektionssystem gemäß Anspruch 8 oder 9; und einer Einrichtung (921) zum Reinigen der Oberfläche der Maske;

wobei die Maske im Betrieb **durch** das Inspektionssystem inspiziert wird.

## Revendications

**1.** Procédé de contrôle comprenant :

la formation d'un premier faisceau d'une première polarisation et d'une première longueur d'onde, et d'un second faisceau d'une seconde polarisation, différente de la première polarisation, et d'une seconde longueur d'onde différente de la première longueur d'onde ; la déviation des premier et second faisceaux à la manière d'un balayage ; l'illumination d'une surface devant être contrôlée avec au moins le premier faisceau dévié et animé d'un mouvement de balayage ; et la détection d'un faisceau d'interférence de battement résultant d'une interférence de battement entre le second faisceau et un faisceau dispersé à partir de la surface illuminée par le premier faisceau, le faisceau dispersé ayant sa polarisation modifiée à partir de la première polarisation par une dispersion provoquée par une particule étrangère, le faisceau dispersé étant placé à l'intérieur d'un quadrant d'une sphère dont la base est parallèle au plan de la surface contrôlée, le centre de ladite sphère étant le point où le premier faisceau atteint la surface contrôlée, et un angle obtus étant formé entre le faisceau incident de contrôle et le faisceau dispersé dans le plan de la surface contrôlée.

**2.** Procédé selon la revendication 1, dans lequel ladite étape de détection comprend l'utilisation d'un réseau de diffraction pour combiner le second faisceau avec le faisceau dispersé.

**3.** Procédé selon la revendication 1 ou la revendication 2, dans lequel ladite étape d'illumination comprend une illumination par balayage de la même position de la surface, avec à la fois le premier et le second faisceau dans des directions d'incidence mutuellement différentes.

**4.** Procédé selon l'une quelconque des revendications précédentes, dans lequel la surface devant être contrôlée est la surface d'un réticule ou d'un masque ayant un motif, dans lequel le contrôle est réalisé pour détecter une particule étrangère quelconque sur la surface tout en la distinguant du motif.

**5.** Procédé selon l'une quelconque des revendications précédentes, dans lequel le faisceau d'interférence est produit alors que le second faisceau n'est pas dirigé sur la surface contrôlée.

**6.** Procédé selon l'une quelconque des revendications précédentes et comprenant l'étape suivante consistant à projeter un motif sur une tranche pour exposer la tranche, puis à effectuer le contrôle de la tranche.

**7.** Procédé selon la revendication 6 et comprenant l'étape consistant à nettoyer une tranche exposée.

8. Système de contrôle agencé pour mettre en oeuvre un procédé de contrôle selon l'une quelconque des revendications 1 à 4, comportant :

une source de lumière (2001, 2101, 2131) destinée à former les premier et second faisceaux ; un miroir de balayage (2102) destiné à balayer la surface devant être contrôlée avec au moins le premier faisceau ; et un détecteur (2011, 2114) destiné à détecter le faisceau d'interférence de battement.

9. Appareil selon la revendication 8, dans lequel la source de lumière comprend une source de lumière laser.

10. Système d'exposition destiné à imprimer un motif d'un masque sur une pièce, **caractérisé par** :

un appareil de contrôle selon l'une des revendications 8 et 9 ; et des moyens (901, 909) destinés à projeter le motif du masque sur la pièce (910) ;

dans lequel, dans le fonctionnement du système, le masque est contrôlé par ledit appareil de contrôle.

11. Système de nettoyage destiné à nettoyer un masque et **caractérisé par** :

un appareil de contrôle selon l'une des revendications 8 et 9 ; et des moyens (921) destinés à nettoyer la surface du masque ;

dans lequel, en fonctionnement, le masque est contrôlé par ledit appareil de contrôle.

FIG. 1

SIGNAL PROCESSING SYSTEM

P,ω₁
S,ω₂

EP 0 598 582 B1

EP 0 598 582 B1

F I G.  2

# FIG. 3

FIG. 4

EP 0 598 582 B1

FIG. 5

EP 0 598 582 B1

2101

2106,2107                    2104,2105   2103

2109

2108

2110

FIG. 6

EP 0 598 582 B1

2102

FIG. 7

FIG. 8

FIG. 9

F I G. 10

EP 0 598 582 B1

FIG. II

F I G. 12

EP 0 598 582 B1

2121

# FIG. 13

FIG. 14

EP 0 598 582 B1

FIG. 15

F I G. 16 A

F I G. 16 B

F I G. 17

EP 0 598 582 B1

**FIG. 18**

EP 0 598 582 B1

SIGNAL
PROCESSING
SYSTEM

FIG. 19